# EUROPEAN PATENT SPECIFICATION

(11) **EP 4 331 020 B1**
(45) Date of publication and mention of the grant of the patent: **15.04.2026**
(21) Application number: 22796298.2
(22) Date of filing: 26.04.2022
(51) Int. Cl.: H02N 2/18, B64C 27/00

(54) **AN ELECTRICITY GENERATION SYSTEM**
STROMERZEUGUNGSSYSTEM
SYSTÈME DE PRODUCTION D'ÉLECTRICITÉ

(30) Priority: 29.04.2021 TR 202107301
(43) Date of publication of application: 06.03.2024
(73) Proprietor: Tusas- Turk Havacilik Ve Uzay Sanayii Anonim Sirketi, 06980 Kazan/Ankara (TR)
(72) Inventor: SAHIN, Burhan, 06980 Kahramankazan/Ankara (TR); GUNEL, Murat, 06980 Kahramankazan/Ankara (TR)
(74) Representative: Berkkam, Ayfer
(86) International application number: PCT/TR2022/050376
(87) International publication number: WO 2022/231554

(56) References cited:
- WO-A1-2008/111932
- WO-A1-2016/013263
- DE-A1- 102016 212 090
- US-A1- 2017 237 369

## Description

The present invention relates to an electricity generation system enabling conversion of motion energy formed by aerodynamic loads, which occur on the blades during the helicopter flight, into electrical energy.

Helicopters are designed for vertical take-off. Such vehicles use blades for take-off, referred as rotary wing systems. Blades, on the other hand, are connected to the rotor and extend outward from the rotor. The blades that the rotor rotates with the control system take different pitch angles during this rotational movement and provide the necessary payload and control for the air vehicle. During the flight, aerodynamic, inertial, static and dynamic loads occur on different axes on the blade. It is seen that these loads are more intense especially in the flutter axis of the blades. As a result of these loadings, the blade is stretched and undergoes elastic deformation. As a result of elastic deformation, motion energy occurs on the blade surface. The word of "piezo" means pressure in Greek. Piezoelectric, on the other hand, is called the ability of a material to change an electric field or electric potential as a result of mechanical pressure applied on the materials. The piezoelectric materials are characterized in that they produce electric current when they are under the influence of a pressure, depending on their crystal structure, and they change shape at a certain level in proportion to the approximate volume when they are under the influence of an electric field. If pressure is applied to an asymmetric ionic crystal with continuous polarization, the distance between the poles decreases and the charge accumulation on its surface increases. Therefore, a potential difference arises between the two terminal points, and if it is combined with a conductor, current flows. Thus, the mechanical effect is converted into electrical magnitude.

US10065731B2, which is included in the known-state of the art, discloses a piezoelectric material that can convert the vibration occurred in said structural parts and/or rotor blades of a helicopter into electrical energy and allows the stiffness of the structural part to be changed with this electrical energy. According to the invention, the structural parts made of piezo electricity are aimed to be used as actuators. In addition, it is able to convert vibration into electrical energy. Said document discloses only the transformation of the vibration that occurs in the vehicle in any situation.

EP2152575B1, which is included in the known-state of the art, discloses a piezoelectric material located at the end of a rotor blade and placed between two electrodes, through which the electrical energy required for the operation of the light emitting diode is obtained. Here, the piezoelectric material creates potential difference between the two electrodes due to the vibrations of the rotor blade to power the light emitting diode, and this voltage is transmitted to the lamp. In the aforementioned patent, the mechanical energy received from the vibration of the rotor is converted into electrical energy and transferred to the diode. The piezoelectric material can be located at the tip of the rotor or in the root area where it is attached to the rotor.

Another patent document no. US2017237369A1 discloses an electric power-generating system for a rotor blade, to a lighting system for a rotor blade, to a rotor blade and to a rotor system. The electric power-generating system comprises at least one electromechanical power-converting device; at least one power-guide line connected mechanically to the electromechanical power-converting device, the electromechanical power-converting device being configured in such a way that, during a movement of the power-guide line, the electromechanical power-converting device converts into electric power the forces introduced by the movement of the power-guide line into the electromechanical power-converting device. The mechanical power supplied in this way to the power-converting device is converted by the power-converting device into electric power.

Another patent document no. WO2008111932A1 discloses an autonomous lighting device, and more particularly, to an autonomous lighting device for providing indications of the proximity of a rotor blade of a helicopter. The rotorcraft including a light emitting device configured to provide light on a rotor blade. The light emitting device includes a light emitting diode arranged on the rotor blade; and a power source, wherein the power source is configured to power the light emitting diode due to a movement of the rotor blade.

The article titled "Power Harvesting Using Piezo Electric Materials", DOI: 10.3990/1.9789036535113, which is included in the known-state of the art, discloses conversion of vibration into electrical energy by means of a piezoelectric material. Here, the piezoelectric material is used for a "lag damper" provided in a rotor region of the helicopter, and it is mentioned that the vibrations during the flight are converted into electrical energy and transferred to the electrical systems in the helicopter. Similarly, the places where the loads are distributed are determined by performing deformation analysis on the rotor blade. However, it is stated that it can be used to determine the life of the piezoelectric material on the rotor.

An electricity generation system according to this invention provides an effective, efficient and practical renewable energy production with low energy costs. Thanks to its adaptable structure to changes, its use can be adapted to different designs.

Another object of the invention is to convert the motion energy, which is generated on a blade surface as a result of aerodynamic shear and axial loads, into electrical energy to use it effectively.

The electricity generation system realized to achieve the object of the invention, which is defined in the first claim and other claims dependent thereon, comprises a body provided at air vehicles; at least one rotor extending out of the body and rotating around an axis along which it extends; at least one blade connected to the rotor, which rotates with the rotor around the axis along which the rotor extends, thus obtaining the necessary force to lift the body into the air; a blade tip which is located at the end of a direction along which the blade extends; and at least one plate which is located on the blade and has an energy conversion function due to its piezoelectric structure.

The electricity generation system according to the invention comprises the plate which is fixed on the blade so as to be integrated with an aerodynamic surface of the blade, enables the conversion of mechanical energy caused by elastic deformation of the blade oscillated by aeroelastic forces into electrical energy, and converts the stress and/or strain caused by the elastic deformation on the blade into electrical energy with its piezoelectric structure; a first region (I) located on the blade closer to the blade tip; a second region (II) located on the blade between the rotor and the first region (I), wherein the distance between the first region (I) and the second region (II) is at least as much as the distance between the second region (II) and the rotor, wherein a plurality of plates are fixed on the blade so as to be only in the first region (I) and only in the second region (II).

In an embodiment of the invention, the electricity generation system comprises the second region (II) located away from the rotor by at least 25% to 35% of the distance between rotor and blade tip; and the first region (I) located away from the rotor by at least 80% to 90% of the distance between rotor and blade tip.

In an embodiment of the invention, the electricity generation system comprises the plate placed in the first region (I) and/or the second region (II) where shear strain and axial strain are equal in at least one point of the aerodynamic surface of the blade during the flight of the air vehicle.

In an embodiment of the invention, the electricity generation system comprises the plate located in any area between the leading edge and the trailing edge.

In an embodiment of the invention, the electricity generation system comprises a first plate located in the first region (I) and/or the second region (II) so as to be closer to the leading edge; and a second plate located to be closer to the trailing edge.

In an embodiment of the invention, the electricity generation system comprises the first plate fixed on the blade at the area close to the blade tip with respect to the second plate.

In an embodiment of the invention, the electricity generation system comprises a plurality of plates located parallel to each other in the first region (I) and/or the second region (II).

In an embodiment of the invention, the electricity generation system comprises the plate form-fitting with the surface of the blade.

In an embodiment of the invention, the electricity generation system comprises the plate, wherein the length of the plate on the axis that the blade extends is greater than the length of the plate on another axis which is substantially perpendicular to the former axis.

In an embodiment of the invention, the electricity generation system comprises at least one electrically powered device located in any part of the body; and a plurality of plates connected to each other in series and/or parallel according to the current and voltage requirements of the device.

In an embodiment of the invention, the electricity generation system comprises the plate capable of producing electric current with the motion energy created under the influence of a force, due to its crystal structure, wherein the plate is made of at least one of the piezoelectric materials such as lead-zirconium-titanate (PZT), quartz (SiO2), barium titanate (BaTiO3), lead zirconate (PbZrO3) or lead titanate (PbTiO3).

In an embodiment of the invention, the electricity generation system comprises at least one cable that transmits the electrical energy produced by the piezoelectric property of the plate; and at least one battery that provides storage of the electrical energy transmitted via the cable and/or feeding of the device through said electrical energy.

In an embodiment of the invention, the electricity generation system comprises the battery that the rotor triggers and rotates, thus storing electrical energy during the movement of the blade, which is in motion.

In an embodiment of the invention, the electricity generation system comprises the plate and/or the battery that supplies devices such as sensors, anti-ice or lighting devices with electrical energy.

The electricity generation system realized to achieve the object of the present invention is illustrated in the attached drawings, in which:
Figure 1 is a perspective view of the electricity generation system
Figure 2 is a schematic view of the electricity generation system.

All the parts illustrated in figures are individually assigned a reference numeral and the corresponding terms of these numbers are listed below:
- 1.: Electricity generation system
- 2.: Body
- 3.: Rotor
- 4.: Blade
- 5.: Blade tip
- 6.: Plate
- 601.: First Plate
- 602.: Second Plate
- 7.: Battery
- (I): First Region
- (II): Second Region
- (d): Device
- (k): Cable

The electricity generation system (1) comprises a body (2) provided at air vehicles; at least one rotor (3) extending longitudinally out of the body (2) and rotating around an axis along which it extends; at least one blade (4) connected to the rotor (3), which, upon triggering of the rotor (3), rotates around the axis along which the rotor (3) extends, thus creating an aerodynamic lifting force required for the body (2) to take-off; a blade tip (5) which is located on the blade (4), at the end of a direction along which the blade (4) extends; and at least one plate (6) made of a piezo-electric material, which is located on the blade (4) and enables energy conversion.

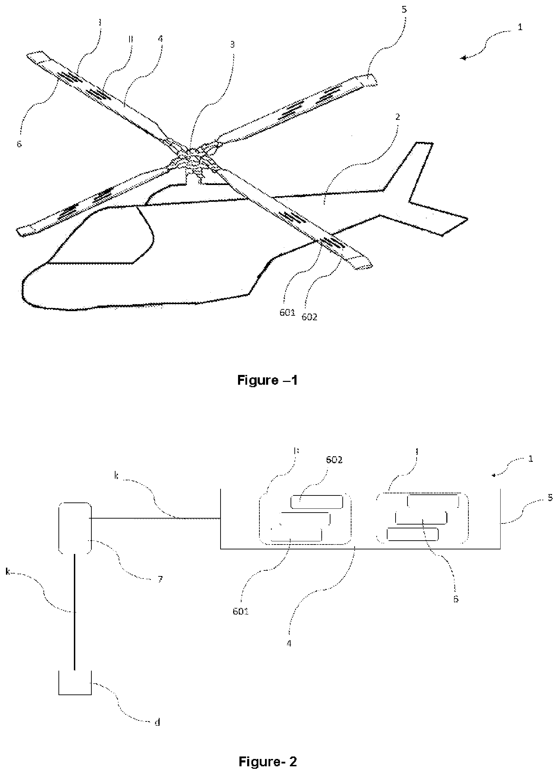

The electricity generation system (1) according to the invention comprises the plate (6) which is located on the blade (4) so that it is integral with an aerodynamic surface of the blade (4), allows the mechanical energy of elastic deformation on the blade (4) oscillating due to aeroelastic forces to be converted into electrical energy, and enables conversion of the tension and/or strain occurring on the blade (4) due to the elastic deformation of the blade (4) into electrical energy due to its piezo-electric structure; a first region (I) located on the blade (4) closer to the blade tip (5); a second region (II) located on the blade (4) between the rotor (3) and the first region (I), wherein the distance between the first region (I) and the second region (II) is at least as much as the distance between the second region (II) and the rotor (3), wherein a plurality of plates (6) are located on the blade (4) so as to be only in the first region (I) and only in the second region (II) (Figure 1).

The body (2) is enabled to be lifted into the air and caused to fly since a body (2) provided at air vehicles, at least one rotor (3) extending longitudinally out of the body and rotating around its axis to transfer power and at least one blade (4) rotating around the rotor (3) axis with the power transmitted by the rotor (3) can provide aerodynamic forces. On the blade (4), there is provided a blade tip (5) located at the end of the direction that the blade (4) extends, which is at the furthest distance from the rotor (3). The system comprises at least one plate (6) on the blade (4), which is fixed to the blade (4), made of a piezoelectric material, and capable of converting motion energy into electrical energy and/or converting electrical energy into motion energy.

The plate (6) located on a surface of the blade (4) facing the inside of the blade (4), fixed on the blade (4) so as to be integrated with an aerodynamic surface of the blade (4), and enabling the mechanical energy caused by the elastic deformation on the surface of the blade (4) rotating on the rotor (3) axis during flight to be converted into electrical energy, enables conversion of the stress and/or strain, which is caused by the elastic deformation on the blade (4), to electrical energy due to its piezoelectric structure. There is provided a first region (I) provided on the blade (4) and located closer to the blade tip (5) than the rotor (3); and a second region (II) located on the blade (4) within a region between the rotor (3) and the first region (I). The first region (I) and the second region (II), which have a distance therebetween at least as much as the distance between the second region (II) and the rotor (3), comprise a plurality of plates (6) located on the blade (4) only in the first region (I) and only in the second region (II). Therefore, the motion energy caused by aeroelastic loads such as shear and axial loads acting on the blade (4) can be converted into electrical energy in a low cost and effective manner.

In an embodiment of the invention, the electricity generation system (1) comprises the second region (II) located away from the rotor (3) by at least 25% to 35% of the distance between rotor (3) and blade tip (5); and the first region (I) located away from the rotor (3) by at least 80% to 90% of the distance between rotor (3) and blade tip (5). In the positioning of the first region (I) and the second region (II) which are provided between the rotor (3) and the blade tip (5), the first region (I) is located away from the rotor (3) by at least 80% to 90% of the total length of the blade (4), while the second region (II) is located away from the rotor (3) by at least 25% to 35% of the total length of the blade (4). Therefore, the motion energy caused by aerodynamic loads can be converted into electrical energy in the most effective way.

In an embodiment of the invention, the electricity generation system (1) comprises the plate (6) located in the first region (I) and/or the second region (II) where shear strain and axial strain are equal in at least one point of the aerodynamic surface of the blade (4) during the flight of the air vehicle. During the flight of the body (2), forces such as shear strain and axial strain, in particular, act on the blade (4). The first region (I) and/or the second region (II) are located in regions where shear strain and axial strain are equal. Thus, the motion energy caused by shear strain and axial loads is effectively converted into electrical energy, thereby reducing electricity generation costs.

In an embodiment of the invention, the electricity generation system (1) comprises the plate (6) located on the blade (4) so as to be between the leading edge and the trailing edge. The plate (6) is located on the blade (4) in any region within the region between the leading edge and the trailing edge. Therefore, motion energy is converted into electrical energy more effectively.

In an embodiment of the invention, the electricity generation system (1) comprises a first plate (601) located to be closer to the leading edge; and a second plate (602) located to be closer to the trailing edge, wherein the first plate (601) and the second plate (602) are located in the first region (I) and/or the second region (II). There is provided a first plate (601) located to be closer to the leading edge than the trailing edge in the first region (I) and/or the second region (II) on the pal (4); and a second plate (602) located to be closer to the trailing edge than the leading edge. Therefore, motion energy is handled more effectively to be converted into electrical energy.

In an embodiment of the invention, the electricity generation system (1) comprises the first plate (601) located on the blade (4) closer to the blade tip (5) than the second plate (602). The position of the first plate (601) on the blade (4) is closer to the blade tip (5) than the second plate (602). Therefore, motion energy is converted into electrical energy in a more effective manner.

In an embodiment of the invention, the electricity generation system (1) comprises a plurality of plates (6) located in the first region (I) and/or the second region (II) so as to extend parallel to each other. The plates (6) extend parallel to each other in the first region (I) and the second region (II). In this way, mechanical energy is converted into electrical energy more efficiently.

In an embodiment of the invention, the electricity generation system (1) comprises the plate (6) form-fitting with the surface of the blade (4). The plates (6) have a form-fitting structure with the surface of the blade (4) in order to form a monolithic structure with the surface of the blade (4). Therefore, the aerodynamic structure of the blade (4) can be maintained.

In an embodiment of the invention, the electricity generation system (1) comprises the plate (6), wherein the length of the plate (6) on the axis that the blade (4) extends is greater than its length on the axis which is substantially perpendicular to the former axis. The dimension of the plate (6) on the axis that the blade (4) extends is greater than its length in the perpendicular axis. Therefore, aerodynamic forces acting on the blade are captured more effectively and converted into electrical energy.

In an embodiment of the invention, the electricity generation system (1) comprises at least one electrically powered device (d) located on the body (2); and a plurality of plates (6) connected to each other in series and/or parallel according to the current and voltage requirements of the device (d). The current and voltages of the electrically powered device (d), which is located in any part of the body (2), must be observed in order for the device to be fed correctly and appropriately. In accordance with the current and voltage characteristics, the plates (6) are connected to each other in parallel and/or series. In this way, it is ensured that the electrical energy obtained from the motion energy is used effectively.

In an embodiment of the invention, the electricity generation system (1) comprises the plate (6) capable of producing electric current when under the influence of a force, due to its crystal structure, wherein the plate (6) is made of at least one of the piezoelectric materials such as lead-zirconium-titanate (PZT), quartz (SiO2), barium titanate (BaTiO3), lead zirconate (PbZrO3) or lead titanate (PbTiO3). The plate (6) made of piezoelectric materials such as lead-zirconium-titanate (PZT), quartz (SiO2), barium titanate (BaTiO3), lead zirconate (PbZrO3) or lead titanate (PbTiO3) converts motion energy into electrical energy due to its crystal structure. Thus, motion energy can be efficiently converted into electrical energy.

In an embodiment of the invention, the electricity generation system (1) comprises at least one cable (k) that enables transmission of the electrical energy produced by the plate (6); and at least one battery (7) that provides storage of the electrical energy transmitted via the cable (k) and/or feeding of the device (d) through said electrical energy. When the plate (6) converts the motion energy into electrical energy, it stores the electrical energy in the battery (7) via the cable (k) so that this electrical energy can be stored and used later. When the plate (6) converts the motion energy into electrical energy, it stores the electrical energy in the battery (7) via the cable (k) so that this electrical energy can be stored and used later. Therefore, the motion energy is effectively converted into electrical energy and stored for later use (Figure 2).

In an embodiment of the invention, the electricity generation system (1) comprises the battery (7) which stores electrical energy during the movement of the blade (4), which is in motion due to the rotational movement of the rotor (3). As long as the rotor (3) moves the blade (4) by making a rotational movement, the mechanical energy is converted into electrical energy. The battery (7) stores this energy throughout the movement. In this way, the continuous storage and use of electrical energy is ensured.

In an embodiment of the invention, the electricity generation system (1) comprises the battery (7) which stores electrical energy during the movement of the blade (4), which is in motion due to the rotational movement of the rotor (3). The battery (7) provides both the storage of energy and the use of the stored electrical energy when necessary. Therefore, electrical energy is stored and used effectively.

In an embodiment of the invention, the electricity generation system (1) comprises the plate (6) and/or the battery (7) that supplies sensors, anti-ice or lighting devices (d). Thus, the stored energy is effectively used where it is needed.

## Claims

1. An electricity generation system (1) comprising a body (2) situated at air vehicles;
at least one rotor (3) extending longitudinally out of the body (2) and rotating around an axis along which it extends; at least one blade (4) connected to the rotor (3), which, upon triggering of the rotor (3), rotates around the axis along which the rotor (3) extends, thus creating an aerodynamic lifting force required for the body (2) to take-off; a blade tip (5) which is located on the blade (4), at the end of a direction along which the blade (4) extends; and at least one plate (6) made of a piezoelectric material, which is located on the blade (4) and enables energy conversion, **characterized by** the plate (6) being located on the blade (4) so that it is monolithic with an aerodynamic surface of the blade (4), allowing the mechanical energy of elastic deformation on the blade (4) oscillating due to aeroelastic forces to be converted into electrical energy, and enabling conversion of the tension and/or strain occurring on the blade (4) due to the elastic deformation of the blade (4) into electrical energy due to its piezoelectric structure; a first region of the electricity generation system
(I) located on the blade (4) closer to the blade tip (5); a second region of the electricity generation system
(II) located on the blade (4) between the rotor (3) and the first region (I), wherein the distance between the first region (I) and the second region (II) is at least as much as the distance between the second region (II) and the rotor (3), wherein a plurality of plates (6) are located on the blade (4) so as to be only in the first region (I) and only in the second region (II).

2. An electricity generation system (1) according to claim 1, **characterized by** the second region (II) being located away from the rotor (3) by at least 25% to 35% of the distance between rotor (3) and blade tip (5); and the first region (1) being located away from the rotor (3) by at least 80% to 90% of the distance between rotor (3) and blade tip (5).

3. An electricity generation system (1) according to claim 1 or claim 2, **characterized by** the plate (6) being located in the first region (I) and/or the second region (II) where shear strain and axial strain are equal in at least one point of the aerodynamic surface of the blade (4) during the flight of the air vehicle.

4. An electricity generation system (1) according to any of the above claims, **characterized by** the plate (6) being located between the leading edge and the trailing edge of the blade (4).

5. An electricity generation system (1) according to any of the above claims, **characterized by** a first plate (601) being located to be closer to the leading edge; and a second plate (602) being located to be closer to the trailing edge, wherein the first plate (601) and the second plate (602) are located in the first region (I) and/or the second region (II).

6. An electricity generation system (1) according to claim 5, **characterized by** the first plate (601) being located on the blade (4) closer to the blade tip (5) than the second plate (602).

7. An electricity generation system (1) according to any of the above claims, **characterized by** a plurality of plates (6) located in the first region (I) and/or the second region (II) so as to extend parallel to each other.

8. An electricity generation system (1) according to any of the above claims, **characterized by** the plate (6) being form-fitting with the aerodynamic surface of the blade (4).

9. An electricity generation system (1) according to any of the above claims, **characterized by** the length of the plate (6) on the axis that the blade (4) extends being greater than its length on the axis which is substantially perpendicular to the former axis.

10. An electricity generation system (1) according to any of the above claims, **characterized by** at least one electrically powered device (d) located on the body (2); and a plurality of plates (6) connected to each other in series and/or parallel according to the current and voltage requirements of the electrically powered device (d).

11. An electricity generation system (1) according to any of the above claims, **characterized by** the plate (6) being capable of producing electric current when under
the influence of a force, due to its crystal structure, wherein the plate (6) is made of at least one of the piezoelectric materials such as lead-zirconium-titanate, PZT, quartz, SiO₂, barium titanate, BaTiO₃, lead zirconate, PbZrO₃ or lead titanate, PbTiO₃.

12. An electricity generation system (1) according to claim 10 or claim 11, **characterized by** at least one cable (k) that provides transmission of the electrical energy produced by the plate (6); and at least one battery (7) that provides storage of the electrical energy transmitted via the cable (k) and/or feeding of the electrically powered device (d) through said electrical energy.

13. An electricity generation system (1) according to claim 12, **characterized by** the battery (7) storing electrical energy during movement of the blade (4), which is in motion due to the rotational movement of the rotor (3).

14. An electricity generation system (1) according to claim 12 or claim 13, **characterized by** the plate (6) and/or the battery (7) supplying sensors, anti-ice or lighting devices (d).

## Patentansprüche

1. Ein Stromerzeugungssystem (1), umfassend einen in einem Luftfahrzeug angeordneten Aufbau (2); mindestens einem Rotor (3), der sich längs aus dem Aufbau (2) erstreckt und um seine Längsachse rotiert; mindestens einem mit dem Rotor (3) verbundenen Blatt (4), das sich bei Drehung des Rotors (3) um seine Längsachse dreht und so die für den Start des Aufbaus (2) erforderliche aerodynamische Auftriebskraft erzeugt; einer Blattspitze (5) am Ende der Längsrichtung des Blatts (4); und mindestens eine Platte (6) aus piezoelektrischem Material, die auf dem Blatt (4) angeordnet ist und die Energieumwandlung ermöglicht, **dadurch gekennzeichnet, dass** die Platte (6) monolithisch mit der aerodynamischen Oberfläche des Blattes (4) verbunden ist und somit die mechanische Energie der elastischen Verformung des aufgrund aeroelastischer Kräfte schwingenden Blattes (4) in elektrische Energie umgewandelt werden kann und die aufgrund der elastischen Verformung des Blattes (4) auftretende mechanische Spannung und/oder Dehnung aufgrund seiner piezoelektrischen Struktur in elektrische Energie umgewandelt werden kann; ein erster Bereich des Stromerzeugungssystems (I), der sich auf dem Blatt (4) in der Nähe der Blattspitze (5) befindet; ein zweiter Bereich des Stromerzeugungssystems (II), der sich auf dem Blatt (4) zwischen dem Rotor (3) und dem ersten Bereich (I) befindet, wobei der Abstand zwischen dem ersten Bereich (I) und dem zweiten Bereich (II) mindestens so groß ist wie der Abstand zwischen dem zweiten Bereich (II) und dem Rotor (3), wobei eine Vielzahl von Platten (6) auf dem Blatt (4) so angeordnet sind, dass sie sich nur im ersten Bereich (I) und nur im zweiten Bereich (II) befinden.

2. Ein Stromerzeugungssystem (1) nach Anspruch 1, **dadurch gekennzeichnet, dass** der zweite Bereich (II) vom Rotor (3) um mindestens 25 % bis 35 % des Abstands zwischen Rotor (3) und Blattspitze (5) entfernt ist; und der erste Bereich (I) vom Rotor (3) um mindestens 80 % bis 90 % des Abstands zwischen Rotor (3) und Blattspitze (5) entfernt ist.

3. Stromerzeugungssystem (1) nach Anspruch 1 oder Anspruch 2, **dadurch gekennzeichnet, dass** die Platte (6) in dem ersten Bereich (I) und/oder dem zweiten Bereich (II) angeordnet ist, in dem die Scherverformung und die axiale Verformung an mindestens einem Punkt der aerodynamischen Oberfläche des Blatts (4) während des Fluges des Luftfahrzeugs gleich sind.

4. Stromerzeugungssystem (1) nach einem der vorstehenden Ansprüche, **dadurch gekennzeichnet, dass** die Platte (6) zwischen der Vorderkante und der Hinterkante des Blatts (4) angeordnet ist.

5. Ein Stromerzeugungssystem (1) nach einem der vorstehenden Ansprüche, **dadurch gekennzeichnet, dass** eine erste Platte (601) näher an der Vorderkante angeordnet ist; und eine zweite Platte (602) näher an der Hinterkante angeordnet ist, wobei sich die erste Platte (601) und die zweite Platte (602) im ersten Bereich (I) und/oder im zweiten Bereich (II) befinden.

6. Ein Stromerzeugungssystem (1) nach Anspruch 5, **dadurch gekennzeichnet, dass** die erste Platte (601) auf dem Blatt (4) näher an der Blattspitze (5) angeordnet ist als die zweite Platte (602).

7. Ein Stromerzeugungssystem (1) nach einem der vorstehenden Ansprüche, **dadurch gekennzeichnet, dass** eine Vielzahl von Platten (6) in der ersten Region (I) und/oder der zweiten Region (II) angeordnet ist und sich parallel zueinander erstreckt.

8. Ein Stromerzeugungssystem (1) nach einem der vorstehenden Ansprüche, **dadurch gekennzeichnet, dass** die Platte (6) formschlüssig mit der aerodynamischen Oberfläche des Blatts (4) verbunden ist.

9. Ein Stromerzeugungssystem (1) nach einem der vorstehenden Ansprüche, **dadurch gekennzeichnet, dass** die Länge der Platte (6) auf der Achse, auf der sich das Rotorblatt (4) erstreckt, größer ist als ihre Länge auf der Achse, die im Wesentlichen senkrecht zu der ersteren Achse verläuft.

10. Ein Stromerzeugungssystem (1) nach einem der vorstehenden Ansprüche, **dadurch gekennzeichnet, dass** mindestens eine elektrisch betriebene Vorrichtung (d) auf dem Gehäuse (2) angeordnet ist und eine Vielzahl von Platten (6), die je nach Strom- und Spannungsbedarf der elektrisch betriebenen Vorrichtung (d) in Reihe und/oder parallel miteinander verbunden sind.

11. Ein Stromerzeugungssystem (1) nach einem der vorstehenden Ansprüche, **dadurch gekennzeichnet, dass** die Platte (6) aufgrund ihrer Kristallstruktur unter Krafteinwirkung elektrischen Strom erzeugen kann, wobei die Platte (6) aus mindestens einem der piezoelektrischen Materialien wie Bleizirkonattitanat (PZT), Quarz (SiO₂), Bariumtitanat (BaTiO₃), Bleizirkonat (PbZrO₃) oder Bleititanat (PbTiO₃) besteht.

12. Ein Stromerzeugungssystem (1) nach Anspruch 10 oder 11, **dadurch gekennzeichnet, dass** mindestens ein Kabel (k) zur Übertragung der von der Platte (6) erzeugten elektrischen Energie und mindestens eine Batterie (7) zur Speicherung der über das Kabel (k) übertragenen elektrischen Energie und/oder zur Versorgung des elektrisch betriebenen Geräts (d) mit dieser elektrischen Energie.

13. Ein Stromerzeugungssystem (1) nach Anspruch 12, **dadurch gekennzeichnet, dass** die Batterie (7) elektrische Energie während der Bewegung des Blatts (4) speichert, welches sich aufgrund der Drehbewegung des Rotors (3) in Bewegung befindet.

14. Ein Stromerzeugungssystem (1) nach Anspruch 12 oder 13, **dadurch gekennzeichnet, dass** die Platte (6) und/oder die Batterie (7) zur Versorgung von Sensoren, Enteisungs- oder Beleuchtungseinrichtungen (d) dient.

## Revendications

1. Système de génération d'électricité (1) comprenant un corps (2) disposé dans un véhicule aérien, au moins un rotor (3) s'étendant longitudinalement hors du corps (2) et tournant autour d'un axe selon lequel il s'étend, au moins une pale (4) reliée au rotor (3) et qui, lors de la mise en rotation du rotor (3), tourne autour de l'axe selon lequel le rotor (3) s'étend, créant ainsi une force de portance aérodynamique nécessaire au décollage du corps (2), une pointe de pale (5) disposée sur la pale (4) à l'extrémité d'une direction selon laquelle la pale (4) s'étend, et au moins une plaque (6) réalisée en matériau piézoélectrique disposée sur la pale (4) et permettant une conversion d'énergie, **caractérisé par le fait que** la plaque (6) est disposée sur la pale (4) de manière à être monolithique avec une surface aérodynamique de la pale (4), permettant de convertir en énergie électrique l'énergie mécanique issue de la déformation élastique de la pale (4) oscillant sous l'effet de forces aéroélastiques et permettant la conversion en énergie électrique des **contraintes et/ou des déformations** apparaissant sur la pale (4) en raison de la déformation élastique de la pale (4) grâce à sa structure piézoélectrique, une première région (I) du système de génération d'électricité étant disposée sur la pale (4) plus proche de l'extrémité de pale (5), une seconde région (II) du système de génération d'électricité étant disposée sur la pale (4) entre le rotor (3) et la première région (I), la distance entre la première région (I) et la seconde région (II) étant au moins égale à la distance entre la seconde région (II) et le rotor (3), une pluralité de plaques (6) étant disposées sur la pale (4) uniquement dans la première région (I) et uniquement dans la seconde région (II).

2. Système de génération d'électricité (1) selon la revendication 1, **caractérisé en ce que** la seconde région (II) est située à une distance du rotor (3) correspondant à au moins 25 % à 35 % de la distance entre le rotor (3) et l'extrémité de pale (5), et la première région (I) est située à une distance du rotor (3) correspondant à au moins 80 % à 90 % de la distance entre le rotor (3) et l'extrémité de pale (5).

3. Système de génération d'électricité (1) selon la revendication 1 ou la revendication 2, **caractérisé en ce que** la plaque (6) est disposée dans la première région (I) et/ou dans la seconde région (II) où la déformation de cisaillement et la déformation axiale sont égales en au moins un point de la surface aérodynamique de la pale (4) pendant le vol du véhicule aérien.

4. Système de génération d'électricité (1) selon l'une quelconque des revendications précédentes, **caractérisé en ce que** la plaque (6) est disposée entre le bord d'attaque et le bord de fuite de la pale (4).

5. Système de génération d'électricité (1) selon l'une quelconque des revendications précédentes, **caractérisé en ce qu**'une première plaque (601) est disposée plus près du bord d'attaque et une seconde plaque (602) est disposée plus près du bord de fuite, la première plaque (601) et la seconde plaque (602) étant disposées dans la première région (I) et/ou dans la seconde région (II).

6. Système de génération d'électricité (1) selon la revendication 5, **caractérisé en ce que** la première plaque (601) est disposée sur la pale (4) plus près de l'extrémité de pale (5) que la seconde plaque (602).

7. Système de génération d'électricité (1) selon l'une quelconque des revendications précédentes, **caractérisé en ce qu**'une pluralité de plaques (6) sont disposées dans la première région (I) et/ou dans la seconde région (II) de manière à s'étendre parallèlement les unes aux autres.

8. Système de génération d'électricité (1) selon l'une quelconque des revendications précédentes, **caractérisé en ce que** la plaque (6) est conformée à la surface aérodynamique de la pale (4).

9. Système de génération d'électricité (1) selon l'une quelconque des revendications précédentes, **caractérisé en ce que** la longueur de la plaque (6) selon l'axe d'extension de la pale (4) est supérieure à sa longueur selon un axe sensiblement perpendiculaire audit axe.

10. Système de génération d'électricité (1) selon l'une quelconque des revendications précédentes, **caractérisé en ce qu**'au moins un dispositif alimenté électriquement (d) est disposé sur le corps (2), et une pluralité de plaques (6) sont connectées les unes aux autres en série et/ou en parallèle selon les exigences de courant et de tension du dispositif alimenté électriquement (d).

11. Système de génération d'électricité (1) selon l'une quelconque des revendications précédentes, **caractérisé en ce que** la plaque (6) est apte à produire un courant électrique sous l'effet d'une force en raison de sa structure cristalline, la plaque (6) étant réalisée en au moins l'un des matériaux piézoélectriques suivants :
zirconate-titanate de plomb, PZT, quartz, SiO₂, titanate de baryum, BaTiO₃, zirconate de plomb, PbZrO₃, ou titanate de plomb, PbTiO₃.

12. Système de génération d'électricité (1) selon la revendication 10 ou la revendication 11, **caractérisé en ce qu'au moins un câble (k)** assure la transmission de l'énergie électrique produite par la plaque (6), et au moins une batterie (7) assure le stockage de l'énergie électrique transmise par le câble (k) et/ou l'alimentation du dispositif alimenté électriquement (d) au moyen de ladite énergie électrique.

13. Système de génération d'électricité (1) selon la revendication 12, **caractérisé en ce que** la batterie (7) stocke l'énergie électrique pendant le mouvement de la pale (4), laquelle est en mouvement en raison du mouvement de rotation du rotor (3).

14. Système de génération d'électricité (1) selon la revendication 12 ou la revendication 13, **caractérisé en ce que** la plaque (6) et/ou la batterie (7) alimentent des capteurs, des dispositifs de dégivrage et/ou des dispositifs d'éclairage (d).
